# DEMANDE DE BREVET EUROPEEN

(11) **EP 1 278 240 A2**
(43) Date de publication de la demande: **22.01.2003**
(21) Numéro de dépôt: 02077496.4
(22) Date de dépôt: 24.06.2002
(51) Int. Cl.: H01L 21/60

(54) **Procédé de report d'un composant sur un support de connexion par soudage sans apport de matière**

(30) Priorité: 10.07.2001 FR 0109169
(71) Demandeur: Koninklijke Philips Electronics N.V., 5621 BA Eindhoven (NL)
(72) Inventeur: Accou, Jan, 75008 Paris (FR)
(74) Mandataire: Chaffraix, Jean

(57) **Abrégé**

La présente invention concerne un procédé de report d'au moins un composant (12) pourvu d'une pluralité de bornes de connexion électrique (18) sur un support de connexion (10), dans lequel :
a) on fournit un support de connexion en un matériau transparent à au moins une longueur d'onde d'un faisceau laser, le support présentant des bornes de réception du composant,
b) on dispose le composant (12) sur le support de connexion (10), en faisant coïncider les bornes de connexion du composant avec les bornes de réception du support,
c) on effectue un soudage des bornes de connexion du composant directement sur les bornes de réception du support par application d'un faisceau laser de soudage sur les bornes de réception, à travers le matériau transparent du support.

## Description

### Domaine technique :

La présente invention concerne un procédé de report d'un ou de plusieurs composants sur un support de connexion. Elle vise notamment l'interconnexion et le conditionnement de composants électroniques ou de composants électro-optiques.

On connaît différents types de supports de connexion. Un premier type de support, désigné par « support d'interconnexion », est destiné à recevoir une pluralité de composants. Il est utilisé comme moyen d'interconnexion de composants, par exemple pour former des circuits électroniques. Un autre type de support, appelé « support intermédiaire », est généralement combiné au composant dans son conditionnement. Le rôle du support intermédiaire est essentiellement d'adapter le pas réduit des bornes de connexion d'un ou de plusieurs composants au pas plus large des cartes de circuit imprimé. Un autre rôle des supports intermédiaires est de réduire, entre les composants et les supports dinterconnexion, ou entre les composants et les cartes de circuit imprimé, les contraintes dues à des différences de coefficients de dilatation thermique.

L'invention trouve ainsi des applications dans le domaine de l'électronique et de l'optoélectronique notamment pour l'interconnexion de composants et/ou leur conditionnement. L'invention concerne en particulier les composants pour téléphones portables.

### Etat de la technique antérieure :

Les documents (1) à (10), dont les références complètes sont précisées à la fin de la description, décrivent différentes techniques connues de connexion électrique et mécanique de composants.

Parmi ces techniques on relève en particulier le report de composants par billes de matériau fusible. Cette technique, encore désignée par « Flip Chip » consiste à garnir des bornes de connexion d'un composant ou les bornes de réception d'un substrat de support, d'un matériau à faible température de fusion. Ce matériau présente généralement la forme de bossages ou de billes. Après avoir disposé le composant sur le substrat de support, en ayant pris soin de faire coïncider les bornes en correspondance, le matériau fusible est chauffé de façon être mis en forme et de façon à souder les bornes de contact sur les bornes de réception. Il s'agit d'un soudage où le matériau fusible constitue un matériau d'apport.

La fusion du matériau fusible peut être provoquée par chauffage de l'ensemble formé par le composant et le support, garnis de billes. Ceci est le cas, notamment lorsque la température de fusion est suffisamment faible pour ne pas altérer le composant. En revanche, lorsque le composant est fragile, on peut aussi chauffer localement le matériau fusible des billes, par exemple au moyen d'un faisceau laser.

La technique d'interconnexion par billes de matériau fusible nécessite un nombre d'étapes de procédé relativement important. Il faut en effet pourvoir le composant et le support de connexion de plots, qui soient isolés les uns des autres et qui soient en un matériau mouillable par le matériau fusible. Il faut ensuite garnir les plots du matériau fusible et il faut enfin procéder au soudage proprement dit.

De plus, les billes de matériau fusible maintiennent un certain espacement entre le ou les composants et le support de connexion. Cet espacement peut, dans certains cas, nuire à la compacité du composant et risque d'être préjudiciable à une bonne protection de celui-ci.

Enfin, les matériaux d'apport pour les soudures, tel le matériau fusible, de même que les couches d'accrochage recevant le matériau fusible, sont susceptibles de contenir du plomb, nocif pour l'environnement.

### Exposé de l'invention :

La présente invention a pour but de proposer un procédé de report ne présentant pas les difficultés ou limitations évoquées ci-dessus.

Un but de l'invention est en particulier de proposer un procédé de report simple et économique qui permette de réduire le nombre d'étapes opératoires.

Un autre but de l'invention est de proposer un procédé qui permette d'éviter l'utilisation du plomb.

L'invention a encore pour but de proposer un conditionnement des composants qui soit particulièrement compact et fiable.

Pour atteindre ces buts, l'invention a plus précisément pour objet un procédé de report d'au moins un composant pourvu d'une pluralité de bornes de connexion électrique, sur un support de connexion, dans lequel :
a) on fournit un support de connexion en un matériau transparent à au moins une longueur d'onde d'un faisceau laser, et présentant au moins une première face avec des bornes de réception en concordance avec les bornes de connexion du composant, les bornes de réception comprenant un matériau susceptible d'être soudé sans apport de matière sur les bornes de connexion du composant,
b) on dispose le composant sur la première face du support de connexion, en faisant coïncider les bornes de connexion du composant avec les bornes de réception du support,
c) on effectue un soudage des bornes de connexion du composant sur les bornes de réception du support par application d'un faisceau laser de soudage sur les bornes de réception, à travers le matériau transparent du support.

L'utilisation d'un matériau transparent pour le support permet d'accéder avec précision aux bornes de réception et d'y appliquer l'énergie nécessaire au soudage. Il convient de souligner que, dans le cas de l'invention, le soudage est un soudage direct du ou des matériaux des bornes de réception sur le ou les matériaux des bornes de connexion. En d'autres termes, aucun matériau fusible, ou métal d'apport, n'est préalablement mis en place sur les bornes.

Le matériau des bornes peut être choisi préférentiellement parmi : le nickel, le fer, et/ou leurs alliages. Ces matériaux ont la particularité de pouvoir être chauffés fortement et de façon localisée au moyen du faisceau laser. Une soudure rapide peut alors être effectuée sans qu'une quantité de chaleur importante soit transmise au support de connexion. Ceci permet de préserver le support des matériaux relativement fragiles. Par ailleurs, la soudure reste limitée aux seules parties des bornes de réception et de contact qui ont été soumises au faisceau laser.

Pour des supports peu sensibles à la chaleur d'autres matériaux peuvent être bien sûr retenus pour la réalisation des bornes de contact ou de réception.

Le soudage des bornes de réception sur les bornes de connexion peut être un soudage pas à pas. Dans ce cas, les différentes paires de bornes en regard sont soudées les unes après les autres. L'utilisation d'un faisceau laser autorise, en effet, des soudages dont la durée est de l'ordre de la microseconde. A titre d'alternative, le soudage de plusieurs paires de bornes peut aussi être concomitant. Ceci peut avoir lieu en ayant recours, par exemple, à des techniques d'holographie pour soumettre le support au laser selon un motif holographique correspondant aux bornes.

L'invention peut, comme indiqué dans la partie introductive, être mise à profit aussi bien pour l'interconnexion de différents composants que pour le conditionnement des composants.

Dans le premier cas, c'est-à-dire celui de l'interconnexion de composants, on peut reporter une pluralité de composants sur un même support pourvu de pistes de connexion reliant sélectivement entre elles différentes bornes de réception.

Les pistes de connexion peuvent ainsi relier électriquement entre elles des bornes d'un même composant ou de composants différents. Elles peuvent aussi servir à relier les composants à des sources d'alimentation en énergie ou à des bornes d'entrée/sortie de signal prévues sur le support de connexion.

Dans des applications de conditionnement des composants, le procédé de l'invention peut être mis en oeuvre pour reporter les composants sur des supports intermédiaires. Comme évoqué dans la partie introductive, les supports intermédiaires peuvent avoir un rôle de protection des composants, un rôle de redistribution des bornes de contact pour en adapter le pas à un support de réception, et enfin un rôle de réduction des contraintes mécaniques dues à des différences de coefficients de dilatation thermique des parties en contact mécanique.

En particulier, le matériau du support de connexion intermédiaire peut être choisi avec un coefficient de dilatation supérieur à celui du composant, et inférieur à celui d'un support de réception final sur lequel le composant, muni du support intermédiaire, doit être reporté. Le support de connexion, utilisé comme support intermédiaire, peut avantageusement être réalisé en un matériau de type sol-gel. Le coefficient de dilatation thermique de ces matériaux peut en effet être aisément contrôlé. De plus, les matériaux sol-gel autorisent la formation d'un support de connexion, dont la face tournée vers le composant en épouse au moins en partie la forme. Un support intermédiaire de type sol-gel peut servir, par exemple, à réaliser un encastrement du composant.

Le support intermédiaire peut comporter, sur sa face opposée au composant, une pluralité de bornes secondaires reliées respectivement aux bornes de réception, par exemple, par l'intermédiaire de trous métallisés. Le pas des bornes secondaires peut être adapté à un support de connexion final auquel est destiné le composant.
Selon une mise en oeuvre particulière du procédé, les bornes secondaires peuvent aussi être décalées par rapport aux bornes de réception dans un plan parallèle aux première et deuxième faces. Ceci autorise l'application d'un faisceau de soudage par la deuxième face et perpendiculairement à celle-ci. Dans ce cas, une épaisseur minimale du support est traversée par le faisceau.

Pour obtenir une pluralité de composants associés individuellement à des supports intermédiaires, on peut reporter les composants, issus d'un même substrat primaire, sur un support de connexion, puis, après le report, découper de façon concomitante le substrat primaire et le support de connexion. Ce découpage permet alors de délimiter des composants, respectivement solidaires de parties de support de connexion dont les dimensions sont ajustées aux composants. Un report individuel de chaque composant sur un support intermédiaire reste cependant possible.

L'invention concerne enfin un dispositif comprenant au moins un composant avec des bornes de connexion et un support de connexion avec des bornes de réception. Conformément à l'invention, le support de connexion est transparent à la lumière et les bornes de réception sont directement soudées contre les bornes de connexion.

D'autres caractéristiques et avantages de l'invention ressortiront de la description qui va suivre, en référence aux figures des dessins annexés. Cette description est donnée à titre purement illustratif et non limitatif.

### Brève description des figures :

La figure 1, est une coupe schématique d'un composant, et d'un support de connexion utilisé comme support intermédiaire, et illustre une étape d'un procédé de report conforme à Invention.

La figure 2, est une coupe schématique d'un composant, et d'un support de connexion utilisé pour l'interconnexion de différents composants.

### Description détaillée de modes de mise en oeuvre de l'invention :

Dans la description qui suit, des parties identiques, similaires ou équivalentes des différentes figures sont repérées par les mêmes signes de référence. Par ailleurs, pour des raisons de clarté des figures, les différentes parties représentées ne le sont pas nécessairement selon une échelle uniforme.

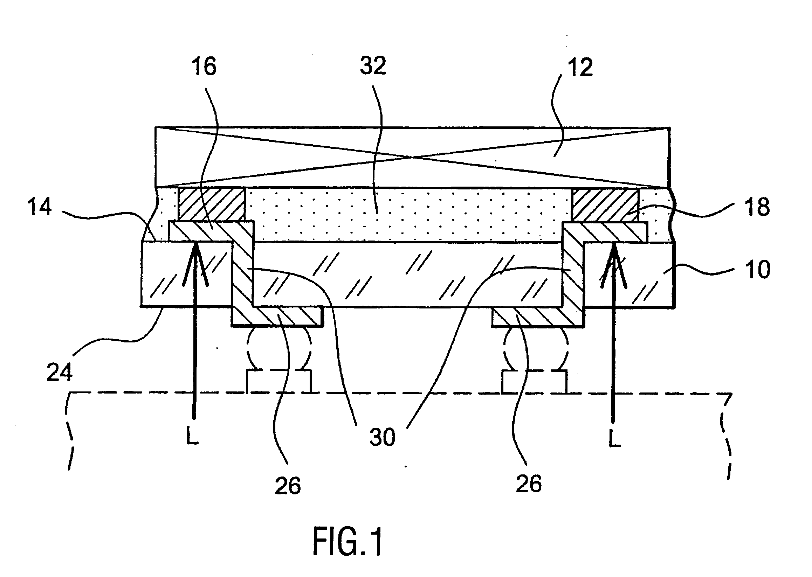

La figure 1 montre un composant électronique 12, tel qu'une puce, reporté sur un support de connexion intermédiaire 10. Le support intermédiaire 10, par exemple une plaque de verre, présente sur une première face 14, tournée vers le composant, une pluralité de bornes de réception 16. Les emplacements des bornes de réception coïncident avec un motif de distribution de bornes de contact 18 du composant 12. Celles-ci sont situées sur une face du composant tournée vers le support intermédiaire. On observe, par ailleurs, que la disposition relative du composant 12 et du support intermédiaire 10 est telle que chaque borne de connexion 18 soit en contact avec l'une des bornes de réception 16. Pour des raisons de clarté, la figure ne représente que deux paires de bornes. Un nombre de bornes bien plus important peut cependant équiper les composants et les supports.

Le support de connexion intermédiaire présente également des bornes secondaires 26 sur une deuxième face 24 opposée à la première face 14. Chaque borne secondaire 26 de la deuxième face est respectivement reliée à une borne de réception 16 de la première face par un trou métallisé 30 qui traverse le support isolant. Les bornes peuvent éventuellement être prolongées et reliées aux trous métallisés par des pistes conductrices.

La fabrication des bornes sur le support de connexion, de même que les pistes conductrices ou les trous métallisés, relève de techniques bien connues en soi. En particulier, les pistes et métallisations peuvent être formées par dépôt, puis lithographie et gravure, par croissance électrochimique, ou encore par sérigraphie. Différentes techniques peuvent également être retenues pour le perçage des trous à travers le support. Ces techniques peuvent être adaptées en fonction du matériau du support. On peut notamment retenir des techniques de gravure ou des techniques d'usinage par laser. L'usinage du verre par laser permet, par exemple, de former des trous dont le diamètre peut être réduit jusqu'à 30µm.

Lorsque le composant 12 est disposé sur le support 10, comme le montre la figure 1, le soudage des bornes de réception 16 sur les bornes de connexion 18 du composant peut avoir lieu. Un faisceau laser, représenté schématiquement par des flèches L, est appliqué sur les bornes de réception 16 à travers le support de connexion 10. Le support de connexion présente en effet la particularité d'être transparent au rayonnement laser. Il offre ainsi un accès aux bornes de réception, indépendamment de l'encombrement du composant ou d'éventuels composants voisins. Le soudage est un soudage direct entre le matériau des bornes de réception et celui des bornes de contact du composant. En d'autres termes, le soudage est un soudage localisé et a lieu sans métal d'apport, sans matériau fusible intermédiaire entre les bornes.

Les bornes 26 de la deuxième face 24 sont de préférence décalées latéralement par rapport aux bornes de réception 16. Ceci permet une application du faisceau laser sous incidence normale au support.

Le faisceau laser peut être appliqué successivement à chacune des bornes à souder ou, de façon collective, à une pluralité de bornes.

La référence 32 indique un matériau de protection du composant mis en place entre le composant et le support intermédiaire. Il s'agit, par exemple, d'un matériau liquide, tel qu'un époxy, susceptible d'être introduit par capillarité, puis réticulé. Le rôle de ce matériau est de protéger le composant, et les bornes de connexion, d'éventuelles agressions chimiques et/ou atmosphériques. Il contribue également à garantir un bon contact mécanique entre le composant et le support intermédiaire en délestant partiellement les bornes des efforts susceptibles d'être exercés entre ces parties. Enfin, dans des applications où le composant est du type optoélectronique, le matériau de protection 32 peut aussi être utilisé comme guide de lumière.

Dans l'utilisation particulière du support de connexion illustrée par la figure 1, celui-ci présente parallèlement au plan de connexion des dimensions sensiblement ajustées à celles du composant. Cette caractéristique peut être obtenue, par exemple, au moyen d'un découpage concomitant d'un substrat comportant le composant et un substrat fournissant le support. Elle procure des avantages importants en termes de compacité, notamment pour des équipements tels que des téléphones portables. Une bonne compacité est également obtenue perpendiculairement au plan de connexion en raison de l'absence de billes de matériau fusible.

Le composant, pourvu de son support intermédiaire, peut ensuite être reporté sur une carte de circuit imprimé ou sur un autre support d'interconnexion. Ce report peut avoir lieu encore conformément à l'invention, ou, de façon classique au moyen de billes de matériau fusible. De telles billes, de même qu'un support d'interconnexion sont esquissés en trait discontinu à titre indicatif.

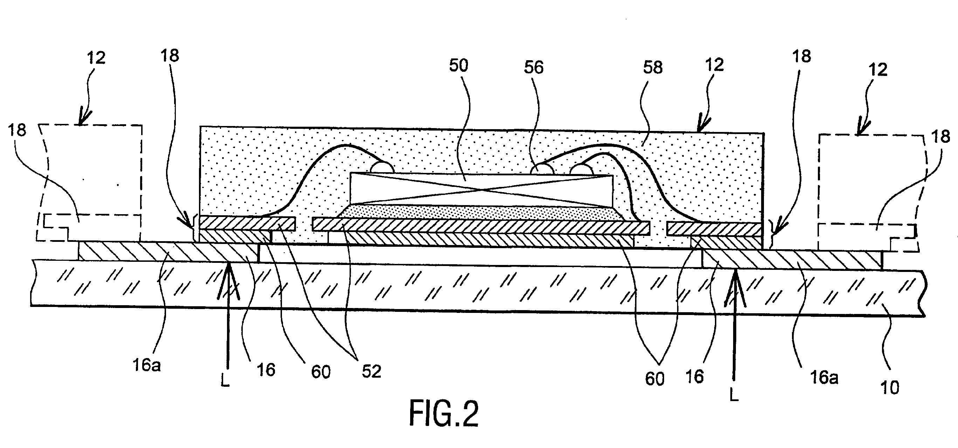

La figure 2, montre le report d'un composant 12 sur un support d'interconnexion 10.

Le composant 12 comporte une puce 50 collée sur un cadre conducteur 52 en cuivre, par une face ne comprenant pas de bornes. Le cadre conducteur présente un certain nombre d'extensions, mutuellement isolées, sous la forme de pattes conductrices 18. Les pattes conductrices sont disposées à la périphérie du cadre 52 et reliées à des bornes 56 de la puce 50. Les bornes 56 se trouvent sur une face du composant opposée au cadre. La connexion des pattes 18 aux bornes 56 est une connexion par fils, bien connue en soi.

Un matériau isolant 58 est utilisé pour le surmoulage de la puce et du cadre conducteur. Le matériau isolant 58 s'étend entre les pattes conductrices 18 sans toutefois en recouvrir la face opposée à la puce. Il en est de même pour la partie du cadre située sous la puce.

Les faces exposées du cadre 52 et des pattes conductrices sont recouvertes d'un plaquage 60. Par exemple de nickel.

Le support d'interconnexion 10, tout comme celui de la figure 1, est en un matériau transparent pour un faisceau laser de soudage. Il présente sur sa face tournée vers le composant des bornes de réception 16 qui se prolongent en des pistes conductrices 16a. Dans l'exemple particulier de la figure 2, les bornes et les pistes ne sont toutefois présentes que sur l'une des faces du support 10.

Les bornes de réception sont mises en contact avec les pattes conductrices 18 qui jouent ici le même rôle que les bornes de connexion du composant de la figure 1.

Le soudage par laser, indiqué avec la référence L, a également lieu à travers le support 10 en mettant à profit ses propriétés de transparence.

D'autres composants reportés sur le même support dinterconnexion sont sommairement représentés en trait discontinu. On peut observer que les pistes conductrices 16a qui prolongent les bornes de réception sur le support d'interconnexion sont également soudées sur les pattes conductrices des autres composants et assurent ainsi l'interconnexion électrique des composants.

### DOCUMENTS CITES

***(1)*** EP-0 918 354-A
***(2)*** EP-0 955 676-A
***(3)*** JP-10 032 224-A
***(4)*** WO-98 33 211-A
***(5)*** WO-00 11 715-A
***(6)*** JP-07 094 845-A
***(7)*** JP-10 022 328-A
***(8)*** US-4 023 005-A
***(9)*** US-5 829 125-A
***(10)*** WO-00 55 925-A

## Revendications

1. Procédé de report d'au moins un composant (12) pourvu d'une pluralité de bornes de connexion électrique (18) sur un support de connexion (10), dans lequel :
a) on fournit un support de connexion (10) en un matériau transparent à au moins une longueur d'onde d'un faisceau laser, et présentant au moins une première face (14) avec des bornes de réception (16) en concordance avec les bornes de connexion (18) du composant, les bornes de réception (16) comprenant un matériau susceptible d'être soudé, sans apport de matière, sur les bornes de connexion du composant,
b) on dispose le composant sur la première face (14) du support de connexion (18), en faisant coïncider les bornes de connexion du composant avec les bornes de réception (16) du support,
c) on effectue un soudage des bornes de connexion du composant directement sur les bornes de réception du support par application d'un faisceau laser de soudage (L) sur les bornes de réception, à travers le matériau transparent du support.

2. Procédé selon la revendication 1, dans lequel on reporte une pluralité de composants sur un même support pourvu de pistes de connexion (16a) reliant sélectivement entre elles des bornes de réception.

3. Procédé selon la revendication 1, dans lequel on reporte au moins un composant (12) sur un support de connexion (10), pourvu, sur une deuxième face (24), opposée à la première face (14), d'une pluralité de bornes secondaires (26), reliées respectivement à des bornes de réception (16) de la première face.

4. Procédé selon la revendication 3, dans lequel les bornes secondaires (26) sont décalées par rapport aux bornes de réception (16) dans un plan parallèle aux première et deuxième faces, pour autoriser l'application d'un faisceau de soudage (L) par la deuxième face et perpendiculairement à celle-ci.

5. Procédé selon la revendication 1, dans lequel on reporte une pluralité de composants solidaires d'un même substrat sur un support de connexion, et dans lequel, après le report, on découpe de façon concomitante le substrat et le support de connexion, pour délimiter des composants solidaires de parties de support de connexion aux dimensions ajustées.

6. Procédé selon la revendication 1, dans lequel, l'étape a) comprend la formation d'un support de connexion (10) à base d'un matériau choisi parmi le verre et des matériaux de type sol-gel, puis la garniture du support avec les bornes de réception.

7. Procédé selon la revendication 6, comprenant la formation d'un support à base de sol-gel avec une première face épousant, au moins en partie, la forme du composant.

8. Procédé selon la revendication 1, dans lequel l'étape a) comprend la formation d'un support de connexion à base d'un matériau présentant un coefficient d'expansion thermique supérieur ou égal à un coefficient d'expansion thermique du composant.

9. Procédé selon la revendication 1, dans lequel on réalise les bornes de réception (16) en un matériau choisi parmi le nickel et/ou le fer et/ou leurs alliages.

10. Procédé selon la revendication 1, comprenant en outre, après l'étape c), la mise en place entre le support de connexion et le composant d'un matériau de protection (32).

11. Procédé selon la revendication 1, dans lequel le soudage des bornes de réception (16) sur les bornes de connexion (18) est un soudage pas à pas.

12. Procédé selon la revendication 1, dans lequel le soudage des bornes de réception (16) sur les bornes de connexion (18) est un soudage collectif à motif holographique.

13. Dispositif comprenant au moins un composant (12) avec des bornes de connexion (18) et un support de connexion (10) avec des bornes de réception (16), **caractérisé en ce que** le support de connexion (10) est transparent à la lumière et **en ce que** des bornes de réception sont directement soudées contre les bornes de connexion.

14. Dispositif selon la revendication 13, dans lequel le support de connexion (10) présente des dimensions sensiblement ajustées sur des dimensions du composant (12).

15. Dispositif selon la revendication 13, dans lequel le composant (12) comprend une puce (50) surmoulée et connectée à un cadre de support métallique (52) à pattes conductrices, les pattes conductrices formant les bornes de connexion (18).
